# EUROPEAN PATENT SPECIFICATION

(11) **EP 0 345 507 B1**
(45) Date of publication and mention of the grant of the patent: **20.07.1994**
(21) Application number: 89109027.6
(22) Date of filing: 19.05.1989
(51) Int. Cl.: H01P 1/205

(54) **Tuneless monolithic ceramic filter**
Nicht-abstimmbares monolithisches Keramikfilter
Filtre céramique monolithique non accordable

(30) Priority: 06.06.1988 US 202623
(43) Date of publication of application: 13.12.1989
(73) Proprietor: MOTOROLA, INC., Schaumburg, IL 60196 (US)
(72) Inventor: Kommrusch, Richard S., Schaumburg Illinois 60194 (US)
(74) Representative: Hudson, Peter David

(56) References cited:
- US-A- 4 266 206
- US-A- 4 716 391
- 42nd ANNUAL FREQUENCY CONTROL SYMPOSIUM-PROCEEDI NGS;june 1-3,1988,Baltimore,US;I.E.E.E.,New York US,1988. G.E.ROBERTS:"A new shutter system for finetuning coupled-dual crystals" pages 211-216

## Description

The present invention relates generally to radio-frequency (RF) signal filters, and, more particularly, to the practice of tuning ceramic RF signal filters.

### Description of the Prior Art

Conventional multi-resonator ceramic filters include a plurality of resonators that are typically foreshortened short-circuited quarter wavelength coaxial or helical transmission lines. The resonators are arranged in a conductive enclosure and may be coupled one to another by apertures in their common walls. Each resonator is commonly tuned to the desired response characteristics in one of two ways.

One way of tuning such resonators is by employing a tuning screw which inserts into a hole extending through the middle of the resonator. Unfortunately, the tuning screw is bulky, it requires mechanical locking elements which can offset the desired coupling between resonators, and, due to the adjustability of the screw before it is locked, it renders these filters susceptible to becoming detuned.

Another way of tuning each resonator is by plating one surface of the ceramic filter at each resonator with conductive plating material. Typically, the surface is plated between the hole in the middle of the resonator and a side wall coupled to the conductive enclosure. This plating is then etched (abraded) away for each resonator in the filter until the desired response characteristics are obtained. This approach is disadvantageous in that it is extremely labour intensive. Plating at each resonator must be repeatedly etched and tested for the desired response characteristics. If too much plating is removed, the filter must be replated or discarded. Moreover, etching the plating often results in etching away some of the ceramic material of the resonator which degrades the coupling consistency between the resonators.

For these reasons, a tuning technique for a ceramic filter is needed which overcomes the foregoing deficiencies.

US Patent No. 4,716,391 describes a dielectric filter as recited in the preamble portion of independent claim 1.

### Summary of the Invention

It is a general object of the present invention to provide a tuning technique for a ceramic filter which overcomes the above-mentioned shortcomings.

In accordance with the present invention there is provided a method of filter manufacture, comprising the steps of:
producing dielectric means comprised of a dielectric material having top, side and bottom surfaces, said dielectric means further having at least two holes extending from the top surface toward the bottom surface thereof and spatially disposed at a predetermined distance from one another, the side and bottom surfaces of said dielectric means selectively covered with a conductive material to provide a transmission line resonator for each of said at least two holes, said method being characterized by the steps of:
measuring a pre-selected frequency related characteristic of said dielectric means;
selecting one of a plurality of artwork masks in response to the measured pre-selected frequency related characteristics; and
applying conductive material to the top surface of said dielectric means using the selected one of said plurality of artwork masks.

Thus, the present invention provides a pretuned ceramic filter which employs predesigned artwork to implement the plating of the top surface of the filter for such tuning. The filter may be implemented in a duplexer.

### Brief Description of the Drawings

The features of the present invention which are believed to be novel are set forth with particularity in the appended claims. The invention, together with further objects and advantages thereof, may best be understood by making reference to the following description taken together with the accompanying drawings, in which reference numerals identify the elements, and wherein:
Fig. 1 is a diagram of a RF radio transceiver employing two filters, according to the present invention;
Fig. 2 is an expanded diagram of one of the filters 114 or 118 of Fig. 1, according to the present invention; and
Fig. 3 is a diagram of an artwork mask, according to the present invention.

### Detailed Description of the Preferred Embodiment

The arrangement disclosed in this specification has particular use for filtering signals in a radio frequency (RF) communication system. More particularly, the arrangement disclosed herein is directed to the manufacture of ceramic filters, their implementation as a duplexer in a radio transceiver.

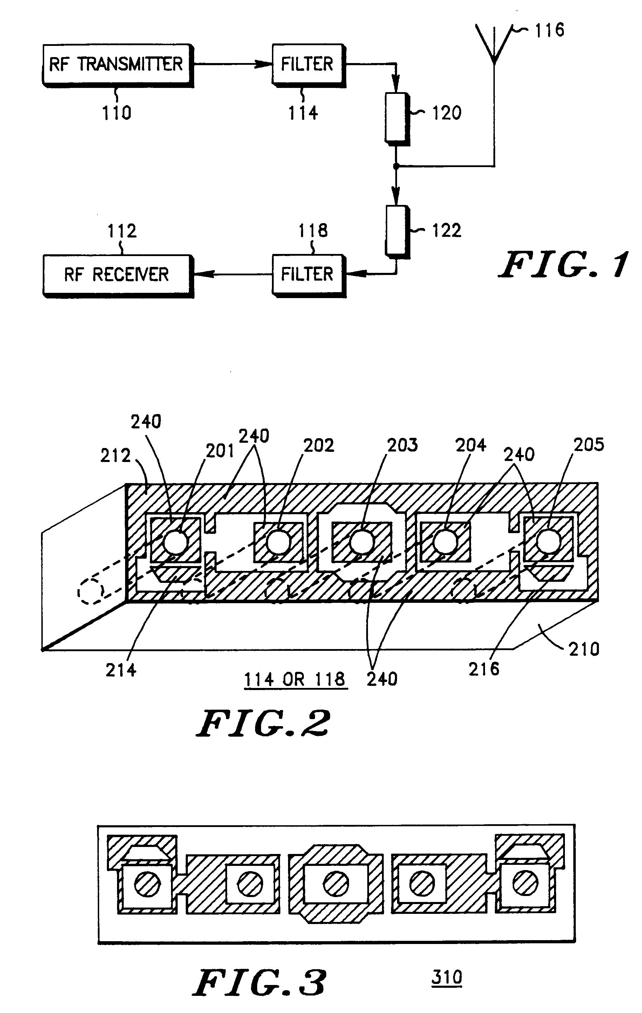

Fig. 1 illustrates such a transceiver. The transceiver includes a conventional RF transmitter 110, and a conventional RF receiver 112. A novel ceramic filter 114, according to the present invention, is used to couple a transmit signal from the RF transmitter 110 to an antenna 116. A similar novel ceramic filter 118 is employed between the antenna 116 and the RF receiver 112 to couple a received RF signal from the antenna 116 to the RF receiver 112. Together, the filters 114 and 118 function as a duplexer to intercouple the antenna 116 to the transceiver. Transmission lines 120 and 122 are respectively disposed between the ceramic filters 114 and 118 and the antenna 116 for proper electrical coupling.

The passband of the filter 114 is centered about the frequency of the transmit signal from RF transmitter 110, while at the same time greatly attenuating the frequency of the received RF signal. In addition, the length of transmission line 120 is selected to maximize its impedance at the frequency of the received signal.

The passband of the filter 118 is centered about the frequency of the received RF signal, while at the same time greatly attenuating the transmit signal. The length of transmission line 122 is selected to maximize its impedance at the transmit signal frequency.

Alternatively, the filters 114 and 118 with elements 120 and 122 can be combined onto a single dielectric block.

In Figure 2, the filter 114 or 118 is shown in detail, according to the present invention. The filter 114 or 118 includes a block 210 which is comprised of a dielectric material that is selectively plated with a conductive material. The block 210 includes input and output electrodes 214 and 216 plated thereon for receiving an input RF signal and for passing a filtered RF signal, respectively. RF signals can be coupled to the electrodes 214 and 216 of the filter 114 or 118 by conventional circuits such as those discussed in U.S. Pat. No. 4,431,977, Sokola et al., assigned to the same assignee and incorporated herein by reference.

The plating on block 210 is electrically conductive, preferably copper, silver or an alloy thereof. Such plating preferably covers all surfaces of the block 210 with the exception of the top surface 212, the plating of which is discussed below. Of course, other conductive plating arrangements can be utilized. See, for example, those discussed in "Ceramic Bandpass Filter", U.S. Pat. No. 4,431,977, Sokola et al., assignee to the present assignee and incorporated herein by reference.

Block 210 includes five holes 201-205, each of which extends from the top surface to the bottom surface thereof. The surfaces defining holes 201-205 are likewise plated with an electrically conductive material. Each of the plated holes 201-205 is essentially a transmission line resonator comprised of a short-circuited coaxial transmission line having a length selected for desired filter response characteristics. Although block 210 is shown with five plated holes 201-207, any number of plated holes can be utilized depending on the filter response characteristics desired. For additional description of the holes 201-205, reference may be made to U.S. Pat. No. 4,431,977, Sokola et al., supra.

Of course, such holes are not essential to filter operation in ceramic filters. For example, ceramic waveguide filters sometimes include resonating section(s) without holes through the dielectric block. See, for example, U.S. Pat. No. 4,691,179, Blum et al., assigned to the same assignee and incorportated herein by reference.

Coupling between the transmission line resonators, provided by the plated holes 201-205, in Fig. 2 is accomplished through the dielectric material and is coursely adjusted by varying the effective width of the dielectric material and the distance between adjacent transmission line resonators. The effective width of the dielectric material between adjacent holes 201-205 can be adjusted in any suitable regular or irregular manner; for example, by the use of slots, cylindrical holes, square or rectangular holes, or irregular shaped holes.

Fine adjustments are made according to the predesigned artwork plating as discussed below.

Furthermore, plated or unplated holes located between the transmission line resonators, provided by holes 201-205, can also be utilized for adjusting the coupling.

According to the present invention, a top surface 212 of the block 210 is selectively plated with a similar electrically conductive material (plating) 240, indicated by shaded areas. The unplated areas of the top surface 212, gaps between the plated areas, are indicated by the unshaded areas. The plating 240 on the top surface of block 210 of Fig. 2 is disposed on the block 210 by using a predesigned artwork mask 310 (Fig. 3), in accordance with the present invention.

The unique mask design is based upon a selected frequency related characteristic of the base dielectric block. Reference to the term "base dielectric block", using Fig. 2 for example, indicates that the block 210 is in a basic form in that there is no plating on the top surface 212. Preferably, the selected frequency related characteristic includes the quarter wave length frequency of the base dielectric block. Alternatively, the height and the dielectric constant of the base dielectric block can be used.

The base dielectric block can be constructed of a suitable dielectric material that has low loss, a high dielectric constant and a low temperature coefficient of the dielectric constant. In a preferred embodiment, the base dielectric block of block 210 is comprised of a ceramic compound including barium oxide, titanium oxide and zirconium oxide, the electrical characteristics of which are described in more detail in an article by G. H. Jonker and W. Kwestroo, entitled "The Ternary Systems BzO-TiO₂-SnO₂ and BaO-TiO₂-ZrO₂", published in the Journal of the American Ceramic Society, volume 41, number 10, at pages 390-394, October 1958. Of the ceramic compounds described in this article, the compound in Table VI having the composition 18.5 mole % BaO, 77.0 mole % TiO₂ and 4.5 mole % ZrO₂ and having a dielectric constant of 40 is well suited for use in the ceramic filter of the present invention.

Such dielectric material is preferably employed as a batch, useful for developing a large number of base dielectric blocks. One batch of such dielectric material, when appropriately used, will provide an equal distribution of the elements making up the compound. An equal distribution will ensure almost exact frequency related characteristics throughout the base dielectric blocks produced therefrom. For example, variance of the quarter wavelength resonant frequency is negligible (measured at less than 0.4% in one application) between the blocks produced from the same batch. However, such a characteristic may be measured on various samples from the batch to ensure consistency.

Once a base dielectric block is produced from the batch, the selected frequency related characteristic is measured to determine the representative frequency related characteristic for the batch or a substantial portion thereof.

Based partly on the representative frequency related characteristic and partly on externally developed filter design specifications, plating artwork useful for selectively plating the conductive material to the top surface of the blocks is designed and then applied to the base dielectric block to provide a complete filter with customized filter characteristics. Preferably, the artwork is developed using conventional computer program modeling and model-to-circuit translations, such as the program entitled "Super-Compact", available from Compact Software, Inc.

The manner in which the plating artwork is used to apply the plating to the base dielectric block can be accomplished using conventional means. For example, an adequate technique uses a dry film imaging transfer system such as Riston^{R} by Du Pont Electronics, Inc., subsidiary of E.I. Du Pont De Nemours & Co. (Inc.).

Variance of the frequency related characteristic between batches can be accommodated by designing several artwork masks to represent needed shifts of the desired center frequency of the filter. For example, consider a quarter wave length base dielectric block frequency of 1 GHz. and a desired filter center frequency of 836.5 MHz. The artwork will be designed to shift the quarter wave length frequency down to 836.5 MHz. However, various batches may result in a quarter wave length base dielectric block frequencies which vary from 0.990 GHz. to 1.010 GHz.(20 MHz. variance). By designing seven artwork masks, each may be designed to shift a quarter wave length base dielectric block frequency as below:

| Artwork | Shift from | Shift to |
|---|---|---|
| 1 | 1.010 GHz. | 836.5 MHz. |
| 2 | 1.007 GHz. | 836.5 MHz. |
| 3 | 1.004 GHz. | 836.5 MHz. |
| 4 | 1.001 GHz. | 836.5 MHz. |
| 5 | 0.998 GHz. | 836.5 MHz. |
| 6 | 0.995 GHz. | 836.5 MHz. |
| 7 | 0.992 GHz. | 836.5 MHz. |

In this manner, a 20 MHz. variance from one batch to the next may be compensated to within 3 Mhz. accuracy by measuring the quarter wavelength frequency characteristic and then selecting the appropriate artwork mask with which to apply the block plating.

Accordingly, where the resonant quarter wavelength frequency of the block is used as the selected frequency related characteristic, the plating artwork is developed to shift the resonant frequency of the block down to the specified centre resonant frequency for the filter design. This processing technique provides significant advantages over the prior art previously discussed. For example, a twelve block study of screen printed and tuned filters included frequency, gap and coupling coefficient measurements. The twelve filters met the desired insertion loss and attenuation specifications as well or better than by abrasive conventional tuning techniques.

## Claims

1. A method of filter manufacture, comprising the steps of:
producing dielectric means (210) comprised of a dielectric material having top (212), side and bottom surfaces, said dielectric means (210) further having at least two holes (201-205) extending from the top surface (212) toward the bottom surface thereof and spatially disposed at a predetermined distance from one another, the side and bottom surfaces of said dielectric means selectively covered with a conductive material to provide a transmission line resonator for each of said at least two holes (201-205), said method being characterized by the steps of:
measuring a pre-selected frequency related characteristic of said dielectric means;
selecting one of a plurality of artwork masks (310) in response to the measured pre-selected frequency related characteristics; and
applying conductive material (240) to the top surface (212) of said dielectric means (210) using the selected one of said plurality of artwork masks.

2. A method, according to claim 1, characterized in that the step of measuring the pre-selected frequency related characteristic includes the step of measuring the quarter wave length frequency of said dielectric means (210).

3. A method, according to claim 1, characterized in that the step of measuring the pre-selected frequency related characteristic includes the step of measuring the height of said dielectric means (210).

4. A method, according to claim 1, characterized in that the step of measuring the pre-selected frequency related characteristic includes the step of measuring the dielectric constant of said dielectric means (210).

5. A method, according to claim 1, characterized in that the step of measuring the pre-selected frequency related characteristic includes the step of measuring the height and the dielectric constant of said dielectric means (210).

6. A method, according to any preceding claim, characterized in that the step of producing said dielectric means (210) includes the step of plating the surfaces of said at least two holes (201-205).

## Patentansprüche

1. Verfahren zur Filterherstellung, umfassend die Schritte:
Herstellen einer dielektrischen Einrichtung (210) gebildet aus einem dielektrischen Material mit oberen (212), seitlichen und unteren Oberflächen, wobei die dielektrische Einrichtung (210) weiter wenigstens zwei Löcher (201-205) besitzt, die sich von der oberen Oberfläche (212) in Richtung auf die untere Oberfläche davon erstrecken und in einem vorbestimmten Abstand voneinander räumlich angeordnet sind, wobei die Seiten- und Bodenflächen der dielektrischen Einrichtung selektiv mit einem leitfähigen Material bedeckt werden, um einen Übertragungsleitungs-Resonator für jedes der wenigstens zwei Löcher (201-205) bereitzustellen, wobei das Verfahren gekennzeichnet ist durch die Schritte:
Messen einer vorgewählten frequenzbezogenen Eigenschaft der dielektrischen Einrichtung;
Auswählen einer aus einer Mehrzahl von Druckvorlagemasken (310) als Reaktion auf die gemessenen vorgewählten frequenzbezogenen Eigenschaften, und
Auftragen eines leitfähigen Materials (240) auf die obere Oberfäche (212) der dielektrischen Einrichtung (210) unter Verwendung der aus der Mehrzahl von Druckvorlagemasken ausgewählten Maske.

2. Verfahren nach Anspruch 1, dadurch gekennzeichnet, daß der Schritt des Messens der vorgewählten frequenzbezogenen Eigenschaft den Schritt des Messens der Viertelwellenlängen-Frequenz der dielektrischen Einrichtung (210) einschließt.

3. Verfahren nach Anspruch 1, dadurch gekennzeichnet, daß der Schritt des Messens der vorgewählten frequenzbezogenen Eigenschaft den Schritt des Messens der Höhe der dielektrischen Einrichtung (210) einschließt.

4. Verfahren nach Anspruch 1, dadurch gekennzeichnet, daß der Schritt des Messens der vorgewählten frequenzbezogenen Eigenschaft den Schritt des Messens der Dielektrizitätskonstante der dielektrischen Einrichtung (210) einschließt.

5. Verfahren nach Anspruch 1, dadurch gekennzeichnet, daß der Schritt des Messens der vorgewählten frequenzbezogenen Eigenschaft den Schritt des Messens der Höhe und der Dielektrizitätskonstante der dielektrischen Einrichtung (210) einschließt.

6. Verfahren nach einem der vorangehenden Ansprüche, dadurch gekennzeichnet, daß der Schritt der Herstellung der dielektrischen Einrichtung (210) den Schritt der Beschichtung der Oberflächen der wenigstens zwei Löcher (201-205) einschließt.

## Revendications

1. Procédé de fabrication de filtre, comprenant les étapes de :
production d'un dispositif diélectrique (210) composé d'un matériau diélectrique ayant des surfaces de dessus (212), latérale et de fond, ledit dispositif diélectrique (210) ayant en outre au moins deux trous (201-205) s'étendant à partir de la surface du dessus (212) en direction de la surface du fond de celui-ci et disposés spacialement à une distance prédéterminée l'un de l'autre, les surfaces latérales et de fond dudit dispositif diélectrique recouvertes sélectivement d'un matériau conducteur pour fournir un résonateur de ligne de transmission pour chacun au moins desdits deux trous (201-205), ledit procédé étant caractérisé par les étapes de :
mesure d'une caractéristique liée à une fréquence présélectionnée dudit dispositif diélectrique ;
sélection d'un masque d'une pluralité de masques de dessin (310) en réponse aux caractéristiques liées à la fréquence présélectionnée mesurée ; et
application d'un matériau conducteur (240) sur la surface du dessus (212) dudit dispositif diélectrique (210) utilisant le masque sélectionné de ladite pluralité de masques de dessin.

2. Procédé, selon la revendication 1, caractérisé en ce que l'étape de mesure de la caractéristique liée à la fréquence présélectionnée comprend l'étape de mesure de la fréquence de quart de longueur d'onde dudit dispositif diélectrique (210).

3. Procédé, selon la revendication 1, caractérisé en ce que l'étape de mesure de la caractéristique liée à la fréquence présélectionnée comprend l'étape de mesure de la hauteur dudit dispositif diélectrique (210).

4. Procédé, selon la revendication 1, caractérisé en ce que l'étape de mesure de la caractéristique liée à la fréquence présélectionnée comprend l'étape de mesure de la constante diélectrique dudit dispositif diélectrique (210).

5. Procédé, selon la revendication 1, caractérisé en ce que l'étape de mesure de la caractéristique liée à la fréquence présélectionnée comprend l'étape de mesure de la hauteur et de la constante diélectrique dudit dispositif diélectrique (210).

6. Procédé, selon l'une quelconque des revendications précédentes, caractérisé en ce que l'étape de fabrication dudit dispositif diélectrique (210) comprend l'étape de plaquage des surfaces desdits au moins deux trous (201-205).
